# EUROPÄISCHE PATENTSCHRIFT

(11) **EP 2 798 922 B1**
(45) Veröffentlichungstag und Bekanntmachung des Hinweises auf die Patenterteilung: **18.05.2016**
(21) Anmeldenummer: 12812281.9
(22) Anmeldetag: 28.12.2012
(51) Int. Cl.: H05K 5/00, H01R 43/16, H01R 43/24

(54) **GEHÄUSE ZUR AUFNAHME EINER ELEKTRONIKEINHEIT**
HOUSING FOR RECEIVING AN ELECTRONIC UNIT
BOÎTIER DE LOGEMENT D'UNE UNITÉ ÉLECTRONIQUE

(30) Priorität: 30.12.2011 DE 102011057193
(43) Veröffentlichungstag der Anmeldung: 05.11.2014
(73) Patentinhaber: Huf Hülsbeck & Fürst GmbH & Co. KG, 42551 Velbert (DE)
(72) Erfinder: NEUHOFF, Stefan, 45239 Essen (DE); SCHINDLER, Justine, 42119 Wuppertal (DE)
(74) Vertreter: Vogel, Andreas
(86) Internationale Anmeldenummer: PCT/EP2012/077032
(87) Internationale Veröffentlichungsnummer: WO 2013/098379

(56) Entgegenhaltungen:
- DE-A1- 3 728 456
- DE-A1- 4 407 508
- DE-A1- 19 820 642
- DE-B3-102008 029 104
- DE-U1- 9 318 985

## Beschreibung

Die Erfindung betrifft ein Gehäuse, das zumindest teilweise in einem Nassbereich eines Kraftfahrzeuges anbringbar ist, zur Aufnahme einer Elektronikeinheit, mit einem Basiselement und einem am Basiselement angeordneten Trägerelement, einer Kavität, die zumindest teilweise durch das Basiselement und das Trägerelement bestimmt ist, und mindestens einem am Trägerelement angeordneten Steckerkontakt, der mit der Elektronikeinheit verbunden ist. Zudem betrifft die Erfindung ein Verfahren zur Herstellung eines Trägerelementes, das an dem soeben genannten Gehäuse befestigbar ist.

Aus dem Stand der Technik ist es bekannt, eine Elektronikeinheit in einem Gehäuse unterzubringen, wobei das Gehäuse, wenn es sich in einem Nassbereich befindet, die Elektronikeinheit vor Umwelteinflüssen, insbesondere Feuchtigkeit, Staub, etc. schützt. Oftmals besteht das Gehäuse aus einer Kavität, in der die Elektronikeinheit sich befindet. Die Kavität wird durch ein Deckelelement verschlossen. Zudem bietet das Gehäuse oftmals außenseitig Steckerkontakte an, um elektronische Bauteile, die sich außerhalb des Gehäuses befinden, mit der innerhalb der Kavität sich befindenden Elektronikeinheit zu verbinden. Die Steckerkontakte erstrecken sich durch eine Wandung des Gehäuses, wobei ein freies Ende sich innerhalb der Kavität befindet und das weitere zweite freie Ende eine Kontaktmöglichkeit zur Außenwelt schafft. Nachteiligerweise hat sich gezeigt, dass Dichtigkeitsprobleme entstehen können, insbesondere an dem Bereich des Gehäuses, durch den der Steckerkontakt verläuft.

Es ist Aufgabe der vorliegenden Erfindung, ein Gehäuse zu schaffen, das die oben genannten Nachteile vermeidet, insbesondere ein Gehäuse bereitgestellt wird, das einfach herzustellen ist und eine zuverlässige Abdichtung der Kavität gewährleistet.

Zur Lösung dieser Aufgabe wird ein Gehäuse mit sämtlichen Merkmalen des Anspruches 1 vorgeschlagen. In den abhängigen Ansprüchen sind bevorzugte Weiterbildungen ausgeführt.

Dazu ist erfindungsgemäß vorgesehen, dass das Trägerelement mit einem Halteteil, durch das zumindest teilweise der Steckerkontakt verläuft, und einem Steckerteil als ein zumindest 2 Komponenten Spritzgussteil ausgebildet ist, und eine Naht zwischen dem Halteteil und dem Steckerteil gebildet ist, die in einem Trockenbereich sich befindet, der vom Nassbereich abschließbar ist. Es hat sich gezeigt, dass es von Vorteil ist den Steckerkontakt durch das Halteteil innerhalb des Trägerelementes zu fixieren. Hierbei stellt das Halteteil eine Komponente des Trägerelementes dar. Die zweite Komponente ist das Steckerteil, das sowohl am Halteteil als auch am Steckerkontakt spritzgegossen ist. Sowohl Halteteil als auch Steckerteil sind aus einem Kunststoffmaterial ausgebildet. Vorteilhafterweise unterscheidet sich das Material des Halteteils vom Material des Steckerteils. Vorteilhafterweise weisen beide Materialien eine gewisse Haftung zueinander auf, wobei folgende Materialpaarungen beispielsweise denkbar sind: PP/PE, PMMA/PS, CA/ABS und PC/ABS. Das Steckerteil hat die Funktion das Halteteil zu umgeben, wobei das Steckerteil mit einer Geometrie ausgebildet ist, mit der es möglich ist, die Kavität des Gehäuses zu verschließen. Das Trägerelement, welches gemäß der vorliegenden Erfindung den Steckerkontakt trägt, hat ferner die Funktion eines Deckels, um zuverlässig eine Abdichtung und Verschließung der Kavität des Gehäuses zu bewirken. Ein Kern dieser Erfindung ist es, dass die Naht, die sich zwischen dem Halteteil und dem Steckerteil bildet, konstruktiv in den Trockenbereich zu legen, sodass ein Eindringen von Umwelteinflüssen durch die generelle Schwachstelle einer Naht, wie sie aus dem Stand der Technik allgemein bekannt ist, nahezu vermieden werden kann.

Vorteilhafterweise ist das Steckerteil außenseitig mit einem Steckerinnenraum ausgebildet, in den ein erstes freies Ende des Steckerkontaktes hineinragt. Der Steckerinnenraum ist durch ein Steckergehäuse begrenzt, wobei ein Stecker am Steckergehäuse aufsetzbar ist, sodass eine elektrische Verbindung zwischen der Elektronikeinheit und einem elektronischen Bauelement außerhalb des Gehäuses herstellbar ist. Im Anwendungsfall des erfindungsgemäßen Gehäuses wird der Steckerinnenraum durch den Stecker verschlossen, sodass der Steckerinnenraum einen Trockenbereich darstellt. In diesem Bereich befindet sich auch das eine Ende der Naht. Das zweite Ende der Naht liegt innerhalb der Kavität, die ebenfalls den Trockenbereich des Gehäuses darstellt.

In einer weiteren die Erfindung verbessernden Maßnahme kann Vorgesehen sein, dass ein zweites freies Ende des Steckerkontaktes die Elektronikeinheit kontaktiert, insbesondere dass das zweite freie Ende des Steckerkontaktes sich durch die Elektronikeinheit erstreckt. Der Steckerkontakt kann ein metallischer Stift sein, der das außerhalb des Gehäuses liegende elektronische Bauelement mit der innerhalb der Kavität sich befindenden Elektronikeinheit verbindet. Die Elektronikeinheit kann eine Platine aufweisen, die über zumindest ein Steckerkontakt mit dem Halteteil verbunden ist. Vorteilhafterweise ist der Steckerkontakt mit der Elektronikeinheit verlötet.

Ebenfalls ist es denkbar, dass eine Labyrinthdichtung zwischen dem Halteteil und dem Steckerteil entlang der Naht sich befindet. Hierbei kann die Naht sich derart zwischen dem Halteteil und dem Steckerteil erstrecken, sodass sich eine Labyrinthdichtung bildet. Beispielsweise ist es möglich, dass die Labyrinthdichtung derart ausgebildet ist, dass die Naht sich in ihrer Länge verlängert. Vorteilhafterweise kann das Steckerteil oder das Halteteil mit einem Dichtungsvorsprung ausgebildet sein, der in das Halteteil oder in das Steckerteil sich erstreckt, sodass sich eine Labyrinthdichtung bildet. Der Dichtungsvorsprung ist vorteilhafterweise im Steckerteil oder im Halteteil integriert. Das bedeutet, dass der Steckerteil mit dem Dichtungsvorsprung bzw. das Halteteil mit dem Dichtungsvorsprung ein gemeinsames monolithisches Bauteil bilden. Es können auch eine Vielzahl an Dichtungsvorsprüngen vorgesehen sein, die eine Labyrinthdichtung innerhalb des Trägerelementes bilden.

Im allgemeinen trägt die oben genannte Labyrinthdichtung dazu bei, dass das Eindringen von Umwelteinflüssen, insbesondere Feuchtigkeit von außen in die Kavität verhindert bzw. möglichst erschwert wird. Erfindungsgemäß befindet sich die Labyrinthdichtung im Trockenbereich des erfindungsgemäßen Gehäuses. Falls der eigentliche Trockenbereich des Steckerinnenraumes durch den am Steckergehäuse angeordneten Stecker nicht vollständig bzw. zufrieden stellend abgeschlossen sein sollte und folglich im geringen Maße zwar Umwelteinflüsse, wie insbesondere Feuchtigkeit in den Steckerinnenraum eindringen würden, verhindert die Labyrinthdichtung, die am Steckerinnenraum angrenzt, wirkungsvoll das Eindringen von Feuchtigkeit in die Kavität.

Vorteilhafterweise ist eine Vielzahl an Steckerkontakten am Trägerelement gehalten, die zueinander beabstandet sind. Hierbei ist es in einer möglichen Ausführungsform der Erfindung denkbar, dass das Halteteil im Bereich zwischen zwei Steckerkontakten eine Ausnehmung aufweist. Die Ausnehmung dient dazu, während des Spritzgussverfahrens des Trägerelementes einen Verbund von Steckerkontakten, die über einen Verbindungssteg zunächst miteinander verbunden sind, zu trennen. Die Ausnehmung legt vorteilhafterweise den Verbindungssteg frei, sodass über ein Werkzeug in die Ausnehmung gefahren werden kann, um eine Trennung des Verbindungssteges zu erzeugen. Der Kurzschluss, der über den Verbindungssteg zwischen zwei benachbarten Steckerkontakten besteht, wird somit aufgehoben.

In einer weiteren die Erfindung verbessernden Maßnahme kann das Trägerelement Befestigungsarme aufweisen, die sich in die Kavität erstrecken und die Elektronikeinheit halten. Die Befestigungsarme können zueinander parallel verlaufen und einen definierten Abstand zueinander aufweisen. Zwischen den Befestigungsarmen befindet sich die E!ektronikeinheit, die durch die Befestigungsarme gehalten ist. Die Befestigungsarme können beispielsweise weitgehend kontaktlos mit der Innenwandung des Basiselementes sein. Hierbei können sich die Befestigungsarme wie auch die Elektronikeinheit in die Kavität des Gehäuses erstrecken. In einer möglichen Ausführungsform der Erfindung hat sich gezeigt, dass es ausreichen kann, dass die Befestigungsarme durch die Kavität sich nicht vollständig erstrecken müssen, um zuverlässig die Elektronikeinheit halten zu können.

Ein weiterer Vorteil der Erfindung ist es, dass die Elektronikeinheit lediglich am Trägerelement des Gehäuses unmittelbar befestigt ist, ohne das Basiselement zu berühren. Falls nun mechanische Kräfte und/oder Spannungen am Basiselement und gleichzeitig am Trägerelement auftreten sollten, ist es ausgeschlossen, dass die Elektronikeinheit dadurch beschädigt werden kann. Die Elektronikeinheit ist lediglich mit dem Trägerelement verbunden, sodass aufgrund der Entkopplung zum Basiselement die Gefahr ausgeschlossen ist, dass die Elektronikeinheit beschädigt werden kann. Das Trägerelement, das zum Einen dafür sorgt, dass zuverlässig die Kavität vom Außenbereich des Gehäuses geschützt und verschlossen ist, hat zum Anderen die Funktion eines Trägers für die Elektronikeinheit, ohne dass die Elektronikeinheit direkt mit dem Basiselement gekoppelt ist.

Vorteilhafterweise befindet sich die Elektronikeinheit in der Kavität des Gehäuses, wobei eine direkte Kontaktierung der Elektronikeinheit mit der Innenwandung des Basiselementes nicht vorliegen muss. Das bedeutet, dass die Elektronikeinheit kontaktlos zum Basiselement innerhalb der Kavität sich befinden kann. Hierbei ist es denkbar, dass die Elektronikeinheit frei schwebend im Basiselement sich befindet und zur Innenwandung des Basiselementes beabstandet ist.

Ferner kann vorgesehen sein, dass die Elektronikeinheit einen Sensor aufweist, der in der Lage ist ein definiertes Bewegungsmuster eines Benutzers außerhalb des Fahrzeuges zu erkennen, um insbesondere einen automatischen Öffnungsvorgang/Schließvorgang der Heckklappe oder eines Kofferraumdeckels auszulösen. Der Sensor kann z. B. eine Fußbewegung des Benutzers detektieren, wodurch die Heckklappe oder der Kofferraumdeckel sich automatisch öffnen/schließen, ohne dass der Benutzer händisch einwirken muss.

Vorteilhafterweise können die Befestigungsarme elastisch verformbar sein. Hierbei können die Befestigungsarme bei der Montage der Elektronikeinheit am Trägerelement leicht verformt werden, bis die Elektronikeinheit ihre definierte Befestigungsstellung am Trägerelement erreicht hat. Anschließend können die Befestigungsarme in ihre Grundstellung sich elastisch zurückverformen, wobei gleichzeitig in dieser Stellung der Befestigungsarme die Elektronikeinheit durch die Befestigungsarme zuverlässig fixiert ist.

Besonders vorteilhaft kann sein, dass das Trägerelement und/oder die Befestigungsarme zumindest eines der folgenden Elemente aufweist: Rastelement, Auflagefläche, Lagerfläche, Anschlagfläche. Somit lässt sich die Elektronikeinheit an mehreren "Befestigungspunkten" bzw. an unterschiedlichen Befestigungsbereichen innerhalb der Kavität fixieren, ohne dass die Gefahr besteht, dass die Elektronikeinheit sich vom Trägerelement lösen kann. Die Befestigungsbereiche bzw. Befestigungspunkte können unterschiedlich ausgebildet sein, wie beispielsweise als Rastelemente, als Clipsverbindungen etc.

Vorteilhafterweise weist das Trägerelement innenseitig eine Dichtung auf, die im zusammengesetzten Zustand an Basiselement des Gehäuses eine zuverlässige Abdichtung der Kavität bewirkt.

Vorteilhafterweise kann der Steckerkontakte L-förmig ausgebildet serin und in den Steckerinnenraum sich erstrecken. Die geometrische Ausgestaltung des Steckerkontaktes in Form einer L-artigen Form bewirkt, dass eine kompakte Bauform des erfindungsgemäßen Gehäuses erzielt werden kann. Das Steckergehäuse, das außenseitig aus dem Gehäuse herausragt, kann z. B. als Buchse ausgeführt sein, in den ein Stecker einsetzbar ist, wodurch ein elektrischer Kontakt zwischen der gehäuseseitigen Elektronikeinheit und einem weiteren elektronischen Bauteil, welches sich z. B. kraftfahrzeugseitig befindet, hergestellt werden kann.

Die oben genannte Aufgabe wird des Weiteren durch ein Verfahren gemäß Patentanspruch 11 gelöst. In den abhängigen Verfahrensansprüchen sind vorteilhafte Weiterbildungen ausgeführt.

Das erfindungsgemäße Verfahren zur Herstellung eines Trägerelementes, das an einem Gehäuse mit einer Elektronikeinheit befestigbar ist und aus einem Halteteil und einem Steckerteil gebildet ist, wobei das Trägerelement eine Vielzahl an Steckerkontakten aufweist, die mit der Elektronikeinheit verbindbar sind, zeichnet sich durch folgende Schritte aus:
A) Bereitstellen eines Verbundes von Steckerkontakten, wobei zumindest ein Verbindungssteg vorgesehen ist, der zwei Steckerkontakte miteinander verbindet,
B) Spritzgießen des Halteteils an den Verbund,
C) Durchtrennen der Verbindungsstege,
D) Spritzgießen des Steckerteils an das Halteteil, wobei während des Spritzgießens ein Werkzeug das Halteteil hält.

Das Halteteil dient unter Anderem dazu, sämtliche Steckerkontakte, die in einem definierten Abstand zueinander angeordnet sind, zu halten, wenn das Steckerteil um die Steckerkontakte spritzgegossen wird. Hierbei hält das Werkzeug der Spritzgussmaschine lediglich das Halteteil, wobei vorteilhafterweise das Werkzeug das Halteteil an einer Innenfläche und einer Außenfläche hält, wobei die Innenfläche in einer Kavität des Gehäuses einsetzbar ist und die Außenfläche an einem Steckerinnenraum des Steckerteils angrenzt, der abschließbar ist. Vorteilhafterweise befindet sich das Halteteil, während es durch ein entsprechendes Werkzeug gehalten wird, schwebend in der Luft in der Spritzgussmaschine, während die Geometrie bzw. der gewünschte Körper des Steckerteils um das Halteteil spritzgegossen wird.

In einer weiteren möglichen Ausführungsform der Erfindung kann während des Schrittes B) und D) eine Labyrinthdichtung am Halteteil und am Steckerteil entstehen.

Ebenfalls ist es denkbar, dass während des Schrittes B) das Halteteil mit Ausnehmungen spritzgegossen wird, wobei eine Ausnehmung jeweils einen Verbindungssteg freilegt, wobei im Schritt C) ein Werkzeug durch die Ausnehmung geführt wird, um eine Durchtrennung des Verbindungssteges auszuführen. Der Vorteil der Ausnehmungen ist, dass lediglich über ein Werkzeug in die Ausnehmungen gefahren werden muss, um den Kurzschluss zwischen zwei jeweils benachbarten Steckerkontakten, durch eine Auftrennung des Verbindungssteges aufzulösen. Der Verbindungssteg hat lediglich die Funktion einen Verbund von Steckerkontakten entstehen zu lassen. Hierdurch kann der Herstellungsaufwand erheblich reduziert werden, da über diesen Verbund gleichzeitig mehrere Steckerkontakte im Trägerelement verarbeitet werden können. Da jedoch im eingebauten Zustand des erfindungsgemäßen Gehäuses keine Verbindung zwischen den Steckerkontakten zu bestehen hat, ist es während des Spritzgießens erforderlich, diesen Verbindungssteg zu durchtrennen.

Weitere Vorteile, Merkmale und Einzelheiten ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine perspektivische Darstellung eines erfindungsgemäßen Gehäuses mit einem Basiselement und einem Trägerelement, an dem eine Elektronikeinheit gehalten ist,
- Fig. 2: das Gehäuse gemäß Figur 1 im montierten Zustand,
- Fig. 3: ein mögliches Ausführungsbeispiel eines Teilbereiches des Trägerelementes,
- Fig. 4: ein erster Verfahrensschritt, bei dem ein Verbund von Steckerkontakten bereitgestellt wird,
- Fig. 5: ein weiterer Verfahrensschritt, bei dem am Verbund ein Halteteil des Trägerelementes spritzgegossen wird,
- Fig. 6: ein weiterer Verfahrensschritt, bei dem Verbindungsstege des Verbundes durchtrennt sind und
- Fig. 7: eine schematische Ansicht des erfindungsgemäßen Gehäuses an einem Kraftfahrzeug.

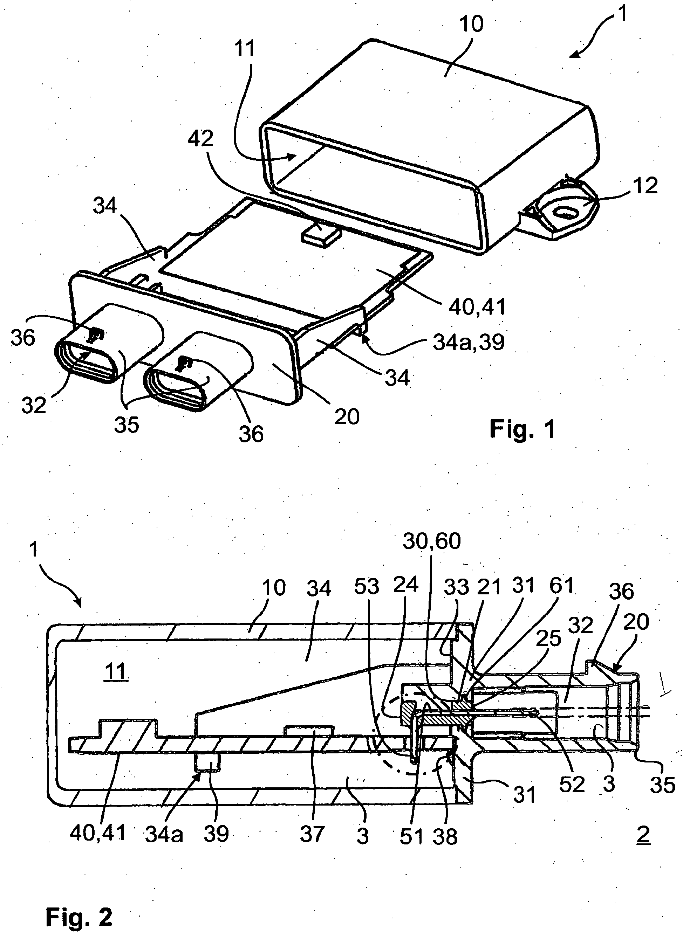

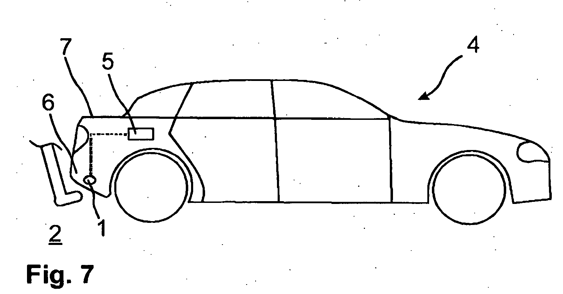

In Figur 1 und Figur 2 ist ein Gehäuse 1 zur Aufnahme einer Elektronikeinheit 40 gezeigt, das gemäß Figur 7 beispielsweise im Außenbereich eines Kraftfahrzeuges 4 befestigbar ist. Der Außenbereich stellt einen Nassbereich 2 dar. Das Gehäuse 1 setzt sich aus einem Basiselement 10 und einem Trägerelement 20 zusammen, wobei durch das Basiselement 10 und das Trägerelement 20 eine Kavität 11 bestimmt ist, in der sich die Elektronikeinheit 40 befindet. Das Trägerelement 20 verschließt abdichtend die Kavität 11, sodass Umwelteinflüsse, wie Feuchtigkeit, Staub etc. nicht in die Kavität 11 gelangen können. Somit wird die Elektronikeinheit 40 zum Einen durch eine nicht explizit dargestellte Dichtung, die zwischen dem Basiselement 10 und dem Trägerelement 20 sich befindet, wirkungsvoll geschützt.

Die Elektronikeinheit 40 ist am Trägerelement 20 befestigt. Das Trägerelement 20 weist eine Stirnwand 33 auf, die zur Kavität 11 gerichtet ist und somit innenseitig der Kavität 11 sich befindet. Das Trägerelement 20 weist zwei Befestigungsarme 34 auf, die als Befestigungselemente für die Elektronikeinheit 40 wirken. Beide Befestigungsarme 34 verlaufen parallel zueinander und erstrecken sich in die Kavität 11. Zudem sind die Befestigungsarme 34 elastisch verformbar ausgebildet, damit die Elektronikeinheit 40 zuverlässig in ihrer befestigten Position gemäß Figur 2 gebracht werden kann

Das Trägerelemente 20 ist mit einem Halteteil 21 und einem Steckerteil 31 ausgebildet. Das Halteteil 21 und das Steckerteil 31 bilden das Trägerelement 20. Hierbei ist das Trägerelement 20 ein 2 Komponenten Spritzgussteil, wobei das Steckerteil 31 am Halteteil 21 angespritzt ist, worauf im Folgenden noch eingegangen wird.

Durch das Halteteil 21 verlaufen metallische Steckerkontakte 51, die mit der Elektronikeinheit 40 in der Kavität 11 kontaktiert sind. Zwischen dem Halteteil 21 und dem Steckerteil 31 bildet sich eine Naht 30. Besonders vorteilhaft ist, dass diese Naht 30 gemäß Figur 2 sich ausschließlich in einem Trockenbereich 3 des Gehäuses 1 befindet, der vom Nassbereich 2 abschließbar ist, worauf im Folgenden ebenfalls noch eingegangen wird.

Das Steckerteil 31 weist einen Steckerinnenraum 32 auf, in dem ein erstes freies Ende 52 des jeweiligen Steckerkontaktes 51 hineinragt. Der Steckerinnenraum 32 ist unter Anderem durch ein Steckergehäuse 35 begrenzt, wobei an das Steckergehäuse 35 ein nicht explizit dargestellter Stecker anbringbar ist, der eine elektronische Verbindung zwischen einem elektronischen Bauteil 5, welches sich gemäß Figur 7 außerhalb des Gehäuses 1 befindet, und der Elektronikeinheit 40 herstellen kann. Das Steckergehäuse 35 weist gemäß Figur 2 außenseitig einen Vorsprung 36 auf, der als Befestigungsmittel für den Stecker wirkt, sodass der Stecker zuverlässig am Steckergehäuse 35 gehalten ist.

Der Steckerkontakt 51 weist ein zweites freies Ende 53 auf, das die Elektronikeinheit 40 in der Kavität 11 kontaktiert. Die Verbindung zwischen dem Steckerkontakt 51 und der Elektronikeinheit 40 kann beispielsweise verlötet sein.

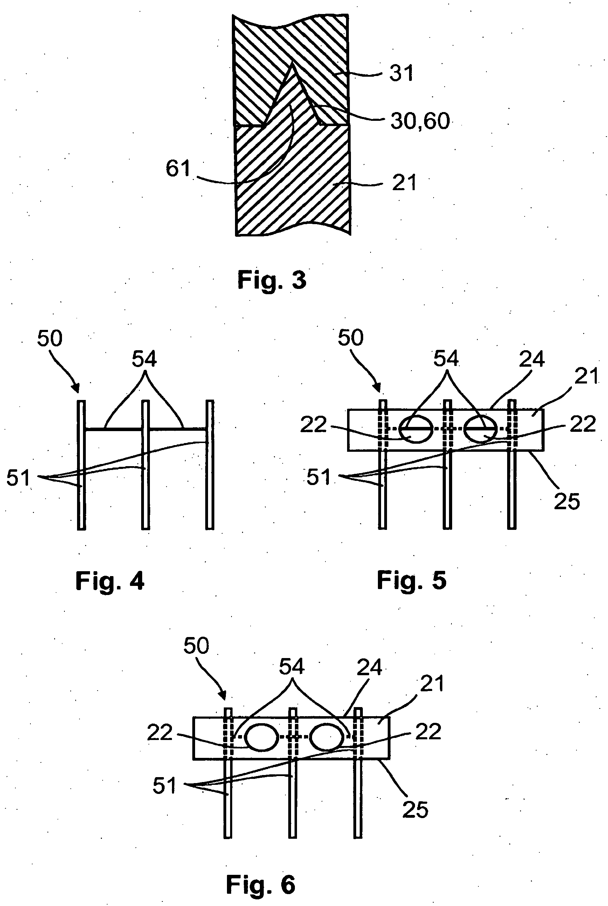

Wie in Figur 2 zu erkennen ist, befindet sich zwischen dem Halteteil 21 und dem Steckerteil 31 eine Labyrinthdichtung 60, die durch den Verlauf der Naht 30 bestimmt ist. Wie in Figur 3 vereinfacht gezeigt ist, weist das Halteteil 21 einen Dichtungsvorsprung 61 auf, der in das Steckerteil 31 sich erstreckt, wodurch sich die Labyrinthdichtung 60 bildet. Da die Naht 30 somit in ihrer Länge aufgrund des Dichtungsvorsprunges 61 verlängert ist, entsteht eine Labyrinthdichtung 60, die wirkungsvoll vermeidet, dass vom Steckerinnenraum 32 Umwelteinflüsse, insbesondere Staub und Feuchtigkeit entlang der Naht 30 in die Kavität 11 gelangen können. Der Steckerinnenraum 32 stellt wie bereits oben erwähnt zwar einen Trockenbereich 3 des Gehäuses 1 dar, da ein Stecker am Steckergehäuse 35 aufgesetzt ist, wodurch der Steckerinnenraum 32 zu einem Trockenbereich 3 wird. Etwaig könnte die Situation jedoch eintreten, dass kleinste Undichtigkeiten an der Verbindung zwischen Stecker und Steckergehäuse 35 auftreten könnten, wodurch die Labyrinthdichtung 60 einem Eindringen von Umwelteinflüssen aus dem Steckerinnenraum 32 in die Kavität 11 entgegenwirkt.

Jeder Befestigungsarm 34 weist eine Auflagefläche 37 auf, an der die Elektronikeinheit 40 anliegt. Die Stirnwand 33 weist zudem eine Auflagefläche 38 auf, auf der die Elektronikeinheit 40 ebenfalls aufliegt, wobei gleichzeitig die Elektronikeinheit 40 die Stirnwand 33 kontaktieren kann.

Zudem weist jeder Befestigungsarm 34 ein freies Ende 34a auf, welches mit einem Rastelement 39 ausgebildet ist, an dem die Elektronikeinheit 40 verrastet ist.

Somit ist die Elektronikeinheit 40 an mehreren Befestigungsbereichen 37, 38, 39 des Trägerelementes 20 fixiert, ohne dass die Gefahr besteht, dass sich die Elektronikeinheit 40 vom Trägerelement 20 lösen kann.

Die Befestigungsbereiche 37, 38, 39 können als Rast- und/oder Clipsmittel ausgeführt sein, damit montagefreundlich die Elektronikeinheit 40 an das Trägerelement 20 befestigt werden kann.

Wie in Figur 2 besonders verdeutlicht ist, ist die Elektronikeinheit 40 lediglich am Trägerelement 20 befestigt und somit mechanisch entkoppelt zum Basiselement 10. Das bedeutet, dass sich die Elektronikeinheit 40 zwar in die Kavität 11 erstreckt, jedoch frei schwebend im Basiselement 10 sich befindet. Es besteht kein direkter Kontakt zwischen der Elektronikeinheit 40 und der Innenwandung des Basiselementes 10. Falls Spannungen am Gehäuse 1, insbesondere am Basiselement 10 und am Trägerelement 20 auftreten sollten, wird wirkungsvoll verhindert, dass die Elektronikeinheit 40 dadurch beschädigt werden kann. Die Spannungen können durch das Trägerelement 20 zwar aufgenommen werden, ohne jedoch schädigende Auswirkungen auf die Elektronikeinheit 40 entstehen zu lassen.

Figur 1 zeigt zudem, dass die Elektronikeinheit 40 eine Platine 41 mit einem Mikrokontroller 42 aufweist. Der Mikrokontroller 42 kann einen Sensor mit aufweisen, der beispielsweise in der Lage ist ein definiertes Bewegungsmuster eines Benutzers außerhalb des Fahrzeuges 4 zu erkennen. Gemäß Figur 7 ist angedeutet, dass der Sensor in dem Gehäuse 1 eine definierte Fußbewegung unterhalb des Stoßfängerüberzuges 6 erkennen kann, um einen automatischen Schließ- und/oder Öffnungsvorgang der Heckklappe 7 des Kraftfahrzeuges 4 auszulösen.

Wie in Figur 2 gezeigt ist, erstreckt sich der Steckerkontakt 51 von der Platine 41 durch das Trägerelement 20 in den Steckerinnenraum 32. Im vorliegenden Ausführungsbeispiel ist der Steckerkontakt 51 L-förmig ausgebildet, wodurch das Gehäuse 1 sowie die Gesamtkonstruktion kompakt gehalten werden kann.

Im vorliegenden Ausführungsbeispiel gemäß Figur 1 und Figur 2 bildet das Trägerelement 20 mit dem Halteteil 21 und dem Steckerteil 31 ein monolithisches Bauteil aus Kunststoff. Gemäß des gezeigten Ausführungsbeispieles unterscheidet sich das Kunststoffmaterial des Halteteiles 21 vom Kunststoffmaterial des Steckerteils 31. Die Befestigungsarme 34 sind einstückig und materialeinheitlich mit dem Steckerteil 31 ausgebildet.

Das Trägerelement 20, das durch das Halteteil 21 und das Steckerteil 31 gebildet ist, wird wie folgt in einem Spritzgussverfahren hergestellt: Zunächst wird ein Verbund 50 von mehreren Steckerkontakten 51 bereitgestellt, wobei jeweils ein Verbindungssteg 54 vorgesehen ist, der jeweils zwei Steckerkontakte 51 miteinander verbindet, welches in Figur 4 schematisch gezeigt ist. Anschließend erfolgt ein Spritzgießen des Halteteils 21 an den Verbund 50, wobei das Halteteil 21 im Bereich der Verbindungsstege 54 an den Verbund 50 spritzgegossen wird. Das Spritzgießen des Halteteils 21 erfolgt in derart, dass nach dem Spritzgießen Ausnehmungen 22 am Halteteil 21 verbleiben, die jeweils einen Verbindungssteg 54 freilegen. Dieses ist in Figur 5 gezeigt. Im weiteren Verfahrensschritt wird ein Werkzeug durch die Ausnehmungen 22 geführt, um eine Durchtrennung der Verbindungsstege 54 auszuführen, da ansonsten ein Kurzschluss zwischen den benachbart angeordneten Steckerkontakten 51 bestehen würde, welches nicht wünschenswert ist. In Figur 6 ist gezeigt, dass die Verbindungsstege 54 durchtrennt sind und somit keine elektronische/elektrische Verbindung zwischen den benachbarten Steckerkontakten 51 besteht.

Das Halbzeug gemäß Figur 6 wird anschließend an der Innenfläche 24 und der Außenfläche 25 des Halteteils 21 durch ein Werkzeug einer Spritzgussmaschine gehalten, wobei im folgenden Schritt das Steckerteil 31 um das Halteteil 21 bzw. um die Steckerkontakte 51 spritzgegossen wird. Anschließend entsteht das Trägerelement 20, welches in Figur 1 bzw. in Figur 2 zu sehen ist, wobei anschließend noch die Elektronikeinheit 40 am Trägerelement 20 zu befestigen ist.

Wie in Figur 1 zu erkennen ist, weist außenseitig das Basiselement 10 zwei Befestigungsmittel 12 auf, an denen das Gehäuse 1 am Fahrzeug 4 fixiert werden kann, beispielsweise über eine Schraubverbindung. Ebenfalls können die Befestigungsmittel 12 als Rastmittel, insbesondere mit Rasthaken oder Rastnasen ausgebildet sein, um eine Clipsverbindung am Fahrzeug 4 herzustellen.

### Bezugszeichenliste

- 1: Gehäuse
- 2: Nassbereich
- 3: Trockenbereich
- 4: Kraftfahrzeug
- 6: Stoßfängerüberzug
- 7: Heckklappe

- 10: Basiselement
- 11: Kavität
- 12: Befestigungsmittel

- 20: Trägerelement
- 21: Halteteil
- 22: Ausnehmung
- 24: Innenfläche
- 25: Außenfläche

- 30: Naht
- 31: Steckerteil
- 32: Steckerinnenraum
- 33: Stirnwand
- 34: Befestigungsarm
- 34a: freies Ende
- 35: Steckergehäuse
- 36: Vorsprung
- 37: Auflagefläche
- 38: Auflagefläche
- 39: Rastelement
- 40: Elektronikeinheit
- 41: Platine
- 42: Mikrokontroller, Sensor

- 50: Verbund
- 51: Steckerkontakt
- 52: erstes freie Ende
- 53: zweites freie Ende
- 54: Verbindungssteg

- 60: Labyrinthdichtung
- 61: Dichtungsvorsprung

## Patentansprüche

1. Gehäuse (1), das zumindest teilweise in einem Nassbereich (2) eines Kraftfahrzeuges (4) anbringbar ist, zur Aufnahme einer Elektronikeinheit (40), mit
einem Basiselement (10) und einem am Basiselement (10) angeordneten Trägerelement (20), einer Kavität (11), die zumindest teilweise durch das Basiselement (10) und das Trägerelement (20) bestimmt ist,
mindestens einem am Trägerelement (20) angeordneten Steckerkontakt (51), der mit der Elektronikeinheit (40) verbunden ist,
**dadurch gekennzeichnet,**
**dass** das Trägerelement (20) mit einem Halteteil (21), durch das zumindest teilweise der Steckerkontakt (51) verläuft, und einem Steckerteil (31) als ein 2 Komponenten Spritzgussteil ausgebildet ist, wobei das Halteteil (21) eine Komponente des Trägerelementes (20) darstellt und wobei die zweite Komponente das Steckerteil (31) ist, das sowohl am Halteteil (21) als auch am Steckerkontakt (51) spritzgegossen ist, und eine Naht (30) zwischen dem Halteteil (21) und dem Steckerteil (31) gebildet ist, wobei sich das eine Ende der Naht (30) in einem Steckerinnenraum (32) befindet und wobei das zweite Ende der Naht (30) innerhalb der Kavität (11) liegt.

2. Gehäuse (1) nach Anspruch 1,
**dadurch gekennzeichnet,**
**dass** das Steckerteil (31) den Steckerinnenraum (32) aufweist, in den ein erstes freies Ende (52) des Steckerkontaktes (51) hineinragt.

3. Gehäuse (1) nach Anspruch 1 oder 2,
**dadurch gekennzeichnet,**
**dass** ein zweites freies Ende (53) des Steckerkontaktes (51) die Elektronikeinheit (40) kontaktiert, insbesondere dass das zweite freie Ende (53) des Steckerkontaktes (51) sich durch die Elektronikeinheit (40) erstreckt.

4. Gehäuse (1) nach einem der vorhergehenden Ansprüche,
**dadurch gekennzeichnet,**
**dass** eine Labyrinthdichtung (60) zwischen dem Halteteil (21) und dem Steckerteil (31) entlang der Naht (30) sich befindet.

5. Gehäuse (1) nach Anspruch 4,
**dadurch gekennzeichnet,**
**dass** die Labyrinthdichtung (60) derart ausgebildet ist, dass die Naht (30) sich in ihrer Länge verlängert.

6. Gehäuse (1) nach einem der vorhergehenden Ansprüche,
**dadurch gekennzeichnet,**
**dass** das Steckerteil (31) oder das Halteteil (21) mit einem Dichtungsvorsprung (61) ausgebildet ist, der in das Halteteil (21) oder in das Steckerteil (31) sich erstreckt, sodass sich eine Labyrinthdichtung (60) bildet.

7. Gehäuse (1) nach einem der vorhergehenden Ansprüche,
**dadurch gekennzeichnet,**
**dass** eine Vielzahl an Steckerkontakten (51) am Trägerelement (20) gehalten sind, die zueinander beabstandet sind.

8. Gehäuse (1) nach Anspruch 7,
**dadurch gekennzeichnet,**
**dass** das Halteteil (21) im Bereich zwischen zwei Steckerkontakten (51) eine Ausnehmung (22) aufweist.

9. Gehäuse (1) nach einem der vorhergehenden Ansprüche,
**dadurch gekennzeichnet,**
**dass** das Trägerelement (20) Befestigungsarme (34) aufweist, die sich in die Kavität (11) erstrecken und die Elektronikeinheit (40) halten.

10. Gehäuse (1) nach einem der vorhergehenden Ansprüche,
**dadurch gekennzeichnet,**
**dass** die Elektronikeinheit (40) am Trägerelement (20) befestigt ist und mechanisch entkoppelt zum Basiselement (10) in die Kavität (11) sich erstreckt.

11. Verfahren zur Herstellung eines Trägerelementes (20), das an einem Gehäuse (1) mit einer Elektronikeinheit (40) befestigbar ist und aus einem Halteteil (21) und einem Steckerteil (31) gebildet ist, wobei das Trägerelement (20) eine Vielzahl an Steckerkontakten (51) aufweist, die mit der Elektronikeinheit (40) verbindbar sind, **gekennzeichnet durch** folgende Schritte:
A) Bereitstellen eines Verbundes (50) von Steckerkontakten (51), wobei zumindest ein Verbindungssteg (54) vorgesehen ist, der zwei Steckerkontakte (51) miteinander verbindet,
B) Spritzgießen des Halteteils (21) an den Verbund (50),
C) Durchtrennen der Verbindungsstege (54),
D) Spritzgießen des Steckerteils (31) an das Halteteil (21), wobei während des Spritzgießens ein Werkzeug das Halteteil (21) hält, wobei eine Naht (30) zwischen dem Halteteil (21) und dem Steckerteil (31) gebildet wird, die sich in einem Trockenbereich (3) befindet, der von einem Nassbereich (2) abschließbar ist.

12. Verfahren nach Anspruch 11,
**dadurch gekennzeichnet,**
**dass** das Werkzeug das Halteteil (21) an einer Innenfläche (24) und einer Außenfläche (25) hält, wobei die Innenfläche (24) in einer Kavität (11) des Gehäuses (1) einsetzbar ist und die Außenfläche (25) an einem Steckerinnenraum (32) des Steckerteils (31) angrenzt, der abschließbar ist.

13. Verfahren nach Anspruch 11 oder 12,
**dadurch gekennzeichnet,**
**dass** während des Schrittes B) und D) eine Labyrinthdichtung (60) am Halteteil (21) und am Steckerteil (31) entsteht.

14. Verfahren nach einem der vorhergehenden Ansprüche,
**dadurch gekennzeichnet,**
**dass** während des Schrittes B) das Halteteil (21) mit Ausnehmungen (22) spritzgegossen wird, wobei eine Ausnehmung (22) jeweils einen Verbindungssteg (54) freilegt, wobei im Schritt C) ein Werkzeug durch die Ausnehmung (22) geführt wird, um eine Durchtrennung des Verbindungssteges (54) auszuführen.

15. Verfahren nach einem der Ansprüche 11 bis 14, wobei das Trägerelement (20) in einem Gehäuse (1) gemäß einer der Ansprüche 1 bis 10 eingesetzt ist.

## Claims

1. Housing (1) that can be at least partially arranged in a wet area (2) of a motor vehicle (4) for receiving an electronics unit (40), with a base element (10) and a carrier element (20) arranged on the base element (10), a cavity (11) which is at least partially defined by the base element (10) and the carrier element (20),
at least one plug contact (51) which is arranged on the carrier element (20) and connected to the electronics unit (40),
**characterised in that**
the carrier element (20) is designed with a holding part (21) through which the plug contact (51) at least partially extends and a plug part (31) as a two component injection moulded component, wherein the holding part (21) is a component of the carrier element (20) and wherein the second component is the plug part (31), which is injection moulded both at the holding part (21) and also at the plug contact (51), and
a seam (30) between the holding part (21) and the plug part (31), wherein one end of the seam (30) is located in a plug interior (32) and wherein the second end of the seam (30) lies within the cavity (11).

2. Housing (1) according to claim 1,
**characterised in that**
the plug part (31) has the plug interior (32) into which a first free end (52) of the plug contact (51) projects.

3. Housing (1) according to claim 1 or 2,
**characterised in that**
a second free end (53) of the plug contact (51) contacts the electronics unit (40), particularly **in that** the second free end (53) of the plug contact (51) extends through the electronics unit (40).

4. Housing (1) according to any one of the preceding claims,
**characterised in that**
a labyrinth seal (60) is located along the seam (30) between the holding part (21) and the plug part (31).

5. Housing (1) according to claim 4,
**characterised in that**
the labyrinth seal (60) is designed in such a way that the seam (30) extends in length.

6. Housing (1) according to any one of the preceding claims,
**characterised in that**
the plug part (31) or the holding part (21) is designed with a seal projection (61) which extends into the holding part (21) or into the plug part (31) so that it forms a labyrinth seal (60).

7. Housing (1) according to any one of the preceding claims,
**characterised in that**
a plurality of plug contacts (51) are held on the carrier element (20) at a distance from one another.

8. Housing (1) according to claim 7,
**characterised in that**
in the area between the two plug contacts (51) the holding part (21) has a recess (22).

9. Housing (1) according to any one of the preceding claims,
**characterised in that**
the carrier element (20) has fastening arms (34) which extend into the cavity (11) and hold the electronics unit (40).

10. Housing (1) according to any one of the preceding claims,
**characterised in that**
the electronics unit (40) is attached to the carrier element (20) and, mechanically uncoupled with regard to the base element (10), extends into the cavity (11).

11. Method of producing a carrier element (20) that can be attached to a housing (1) with an electronics unit (40) and is formed of a holding part (21) and a plug part (31), wherein the carrier element (20) has a plurality of plug contacts (51) which can be connected to the electronics unit (40), **characterised by** the following steps:
A) provision of a grouping (50) of plug contacts (51) wherein at least one connection strip (54) is provided which connects two plug contacts (51) to each other,
B) injection moulding of the holding part (21) onto the grouping (50),
C) severing of the connection strips (54),
D) injection moulding of the plug part (31) onto the holding part (21) wherein during the injection moulding a tool holds the holding part (21) and wherein a seam (30) is formed between the holding part (21) and the plug part (31) which is located in a dry area (3) which can be closed off from a wet area (2).

12. Method according to claim 11,
**characterised in that**
the tool holds the holding part (21) on an inner surface (24) and an outer surface (25), wherein the inner surface (24) can be used in a cavity (11) of the housing (1) and the outer surface (25) adjoins a closable plug interior (32) of the plug part (31).

13. Method according to claim 11 or 12,
**characterised in that**
during steps B) and D) a labyrinth seal (60) is formed on the holding part (21) and on the plug part (31).

14. Method according to any one of the preceding claims,
**characterised in that**
during step B) the holding part (21) is injection moulded with recesses (22) wherein each recess (22) exposes one connection strip (54) wherein in step C) a tool is introduced through the recess (22) in order to sever the connection strip (54).

15. Method according to any one of claims 11 to 14 wherein the carrier element (20) can be used in a housing (1) in accordance with any one of claims 1 to 10.

## Revendications

1. Boîtier (1) apte à être monté au moins partiellement dans une zone humide (2) d'un véhicule automobile (4) et destiné à loger une unité électronique (40), comprenant
un élément de base (10) et un élément de support (20) disposé sur l'élément de base (10), une cavité (11) qui est définie au moins partiellement par l'élément de base (10) et l'élément de support (20),
au moins un contact de connecteur (51) qui est disposé sur l'élément de support (20) et qui est relié à l'unité électronique (40),
**caractérisé en ce**
**que** l'élément de support (20) est réalisé sous la forme d'une pièce moulée par injection à deux composants avec une partie de retenue (21), à travers laquelle s'étend au moins partiellement le contact de connecteur (51), et une partie connecteur (31), la partie de retenue (21) constituant un composant de l'élément de support (20) et le deuxième composant étant la partie connecteur (31), qui est moulée par injection aussi bien sur la partie de retenue (21) que sur le contact de connecteur (51) et
**qu'**une soudure (30) est formée entre la partie de retenue (21) et la partie connecteur (31), une extrémité de la soudure (30) se trouvant dans un espace intérieur du connecteur (32) et la deuxième extrémité de la soudure (30) étant située à l'intérieur de la cavité (11).

2. Boîtier (1) selon la revendication 1,
**caractérisé en ce**
**que** la partie connecteur (31) présente un espace intérieur de connecteur (32) dans lequel pénètre une première extrémité libre (52) du contact de connecteur (51).

3. Boîtier (1) selon la revendication 1 ou la revendication 2,
**caractérisé en ce**
**qu'**une deuxième extrémité libre (53) du contact de connecteur (51) est en contact avec l'unité électronique (40), en particulier que la deuxième extrémité libre (53) du contact de connecteur (51) s'étend à travers l'unité électronique (40).

4. Boîtier (1) selon l'une des revendications précédentes,
**caractérisé en ce**
**qu'**un joint à labyrinthe (60) se trouve entre la partie de retenue (21) et la partie connecteur (31) le long de la soudure (30).

5. Boîtier (1) selon la revendication 4,
**caractérisé en ce**
**que** le joint à labyrinthe (60) est réalisé de façon que la soudure (30) s'étende sur sa longueur.

6. Boîtier (1) selon l'une des revendications précédentes,
**caractérisé en ce**
**que** la partie connecteur (31) ou la partie de retenue (21) est réalisée avec une saillie d'étanchéité (61) qui s'étend dans la partie de retenue (21) ou dans la partie connecteur (31), de sorte qu'il se forme un joint à labyrinthe (60).

7. Boîtier (1) selon l'une des revendications précédentes,
**caractérisé en ce**
**qu'**une pluralité de contacts de connecteur (51), qui sont espacés les uns des autres, sont maintenus sur l'élément de support (20).

8. Boîtier (1) selon la revendication 7,
**caractérisé en ce**
**que** la partie de retenue (21) présente un évidement (22) dans la zone entre deux contacts de connecteur (51).

9. Boîtier (1) selon l'une des revendications précédentes,
**caractérisé en ce**
**que** l'élément de support (20) présente des bras de fixation (34) qui s'étendent dans la cavité (11) et maintiennent l'unité électronique (40).

10. Boîtier (1) selon l'une des revendications précédentes,
**caractérisé en ce**
**que** l'unité électronique (40) est fixée à l'élément de support (20) et s'étend dans la cavité (11) en étant découplée mécaniquement de l'élément de base (10).

11. Procédé de fabrication d'un élément de support (20) qui peut être fixé à un boîtier (1) contenant une unité électronique (40) et qui est formé d'une partie de retenue (21) et d'une partie connecteur (31), l'élément de support (20) présentant une pluralité de contacts de connecteur (51) qui peuvent être reliés à l'unité électronique (40), **caractérisé par** les étapes suivantes :
A) mise à disposition d'un ensemble (50) de contacts de connecteur (51), au moins une entretoise de liaison (54) qui relie deux contacts de connecteur (51) entre eux étant prévue,
B) moulage par injection de la partie de retenue (21) sur l'ensemble (50),
C) sectionnement de l'entretoise de liaison (54),
D) moulage par injection de la partie connecteur (31) sur la partie de retenue (21), un outil maintenant la partie de retenue (21) pendant le moulage par injection et une soudure (30) étant formée entre la partie de retenue (21) et la partie connecteur (31), qui se trouve dans une zone sèche (3) qui peut être fermée par rapport à la zone humide (2).

12. Procédé selon la revendication 11,
**caractérisé en ce**
**que** l'outil maintient la partie de retenue (21) à une surface intérieure (24) et une surface extérieure (25), la surface intérieure (24) pouvant être introduite dans une cavité (11) du boîtier (1) et la surface extérieure (25) étant adjacente à un espace intérieur de connecteur (32) de la partie connecteur (31) qui peut être fermé.

13. Procédé selon la revendication 11 ou la revendication 12,
**caractérisé en ce**
**qu'**un joint à labyrinthe (60) est formé sur la partie de retenue (21) et la partie connecteur (31) pendant les étapes B) et D).

14. Procédé selon l'une des revendications précédentes,
**caractérisé en ce**
**que** pendant l'étape B), la partie de retenue (21) est moulée par injection avec des évidements (22), chaque évidement (22) mettant à découvert une entretoise de liaison (54), un outil étant guidé à travers l'évidement (22) pour sectionner l'entretoise de liaison (54) à l'étape C).

15. Procédé selon l'une des revendications 11 à 14, selon lequel l'élément de support (20) est utilisé dans un boîtier (1) selon l'une des revendications 1 à 10.
